# EUROPÄISCHE PATENTSCHRIFT

(11) **EP 0 492 218 B1**
(45) Veröffentlichungstag und Bekanntmachung des Hinweises auf die Patenterteilung: **26.10.1994**
(21) Anmeldenummer: 91120970.8
(22) Anmeldetag: 06.12.1991
(51) Int. Cl.: H01J 37/02, H01J 37/20

(54) **Kühlvorrichtung für elektronische Bauelemente in einer Vakuumkammer**
Cooling arrangement for electronic devices within a vacuum chamber
Dispositif de refroidissement pour composants électroniques dans une chambre à vide

(30) Priorität: 20.12.1990 DE 4041029
(43) Veröffentlichungstag der Anmeldung: 01.07.1992
(73) Patentinhaber: Siemens Nixdorf Informationssysteme Aktiengesellschaft, 33102 Paderborn (DE)
(72) Erfinder: Gelzer, Friedbert, W-8900 Augsburg (DE); Würtenberger, Volker, Dipl.-Ing., W-8900 Augsburg (DE)
(74) Vertreter: Fuchs, Franz-Josef, Dr.-Ing.

(56) Entgegenhaltungen:
- US-A- 3 086 112
- US-A- 4 565 601
- PATENT ABSTRACTS OF JAPAN, Bd. 12, Nr. 9 (E-572)12. Januar 1988;& JP-A-62 169 330
- PATENT ABSTRACTS OF JAPAN, Bd. 4, Nr. 87 (E-16)21. Juni 1980;& JP-A-55 053 849

## Beschreibung

Die Erfindung betrifft eine Kühlvorrichtung für elektronische Bauelemente, die sich zum Zwecke der Funktionsprüfung mittels gebündelter Elektronen- oder Ionenstrahlen in einer Vakuumkammer befinden.

In Elektronenstrahlmeßgeräten, Rasterelektronenmikroskopen oder fokussierten Ionenstrahlgeräten werden elektronische Bauelemente zum Zwecke einer internen Analyse in der evakuierten Prüfkammer elektrisch betrieben.

Ein solches Elektronenstrahlmeßgerät ist in dem Prospekt der Firma Schlumberger "Technologies IDS 4000 Integrated Diagnostic System", August 1988, beschrieben, mit dem es möglich ist, Fehler bei integrierten Schaltungen oder Leiterplatten rasch und präzise festzustellen.

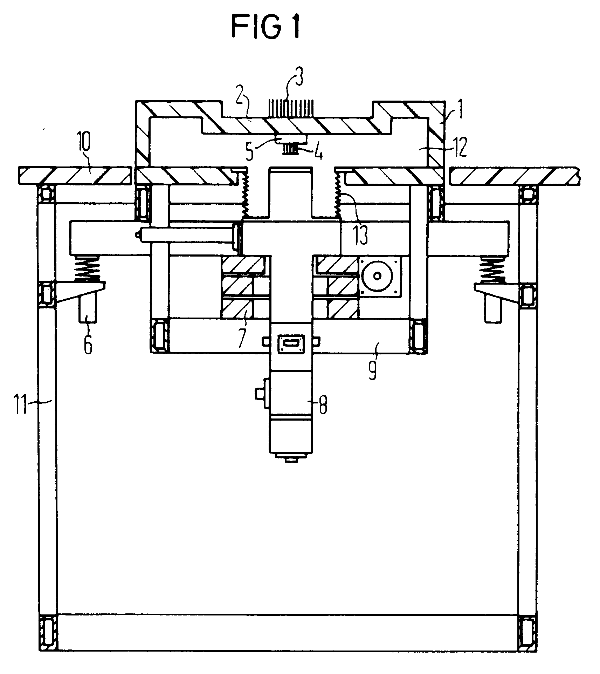

Sein grundsätzlicher Aufbau ist in FIG 1 dargestellt. Die den Elektronenstrahl erzeugende, senkrecht angeordnete optoelektronische Säule 8 wird an einem Aufnahmerahmen 9 gehalten, der zugleich eine Justieranlage 7 enthält, die eine Verschiebung der Säule 8 in der horizontalen XY-Ebene gestattet. Die gesamte Apparatur befindet sich in einem Schrank, der Teil eines Arbeitsplatzes ist, der mit einer Arbeitsplatte 10 abgedeckt ist. Der Prüfling 4 befindet sich im Innern einer Vakuumkammer 12, die über die Abdeckhaube 2, die aus der Arbeitsplatte 10 herausragt, zugänglich ist. An der oberen Innenseite der Abdeckhaube ist eine Fassung 5 zur Aufnahme des Prüflings 4 angebracht und die einzelnen Kontakte dieser Fassung sind vakuumdicht auf die Außenseite der Abdeckhaube 2 in Anschlußstifte 3 geführt. Die optoelektronische Säule ragt mittels eines Balges 13 abgedichtet in die Vakuumkammer 12 hinein.

Die durch die Verlustleistung entstehende Wärme kann nur durch Wärmeleitung aus der Kammer abgeführt werden. Speziell bei bipolaren Schaltkreisen mit ihren Verlustleistungen bis zu 40 Watt, entsteht dabei eine erhebliche Temperaturdifferenz zwischen Sperrschicht und Umgebung, die die Kontrolle der Chiptemperatur erschwert.

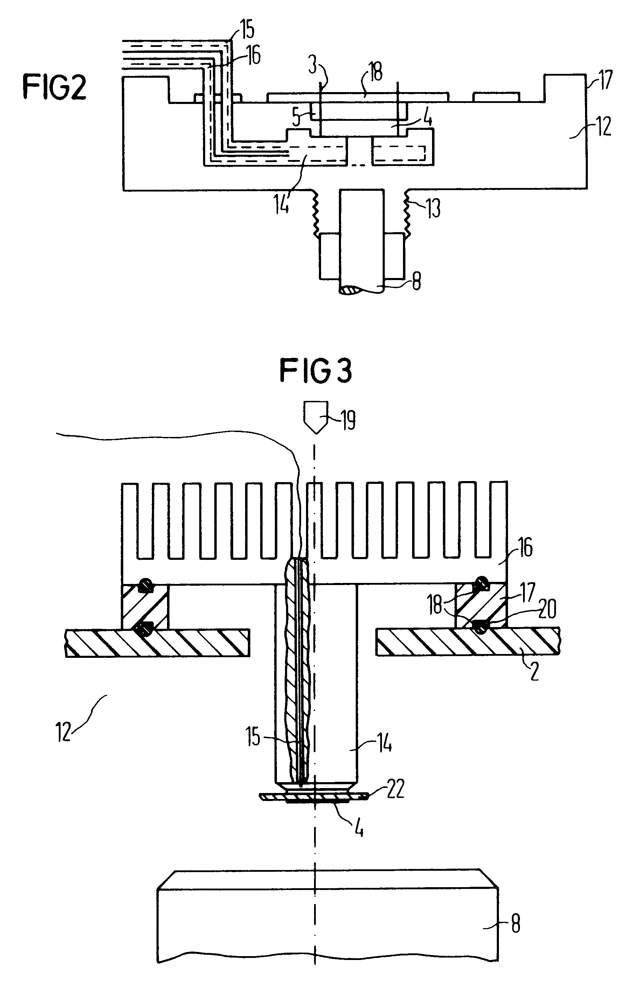

Die im vorgenannten Prospekt beschriebene Lösung nach FIG 2 zeigt einen flüssigkeitsgekühlten Metallblock 14, der in der Vakuumkammer 12 zwischen dem Prüfling 4 und der optoelektronischen Säule 8 montiert ist. Die Kühlflüssigkeit wird über Schläuche 15, 16 aus der Vakuumkammer 12 nach außen geleitet.

Die Wärmeableitung erfolgt über das Gehäusematerial, das neben der aktiven Chipfläche steht. Neben den präperativen Problemen, die dadurch insbesondere für plastikgehäuste Bauteile entstehen, ist auch der Wärmeübergangswiderstand dieser Lösung relativ hoch. Für Bauteile in TAB-Montage (Tape Automatic Bonding) ist diese Lösung gar nicht realisierbar. Nachteilig an dieser Lösung ist außerdem die Notwendigkeit, durchflossene Rohre in die Vakuumkammer einzuführen.

Aufgabe der vorliegenden Erfindung ist es daher, eine Kühlvorrichtung anzugeben, durch die die vorstehend genannten Nachteile vermieden werden.

Zur Lösung dieser Aufgabe wird die Kühlvorrichtung gemäß der Erfindung derart ausgebildet, daß ein stempelartig ausgebildeter Kühlkörper über eine an der Oberseite der Vakuumkammer abgedichtete Öffnung in die Vakuumkammer eingesetzt und mit der Rückseite des Bauelementes unmittelbar kontaktiert ist.

Durch diese Maßnahmen wird eine große Berührungsfläche und eine kurze Entfernung zwischen aktiver Chipseite und Kühlkörper erreicht, was für einen geringen Wärmeübergangswiderstand sorgt.

In weiterer Ausgestaltung ist der Kühlkörper außerhalb der Vakuumkammer mit einer Kühlrippe verbunden, die auf der Abdeckhaube der Vakuumkammer befestigt ist. Die Abführung der Wärme an den Kühlrippen erfolgt über ihnen zugeführter, temperaturgeregelter Kühlluft, wobei der Istwert der Temperaturregelung durch einen Temperaturregler erzeugt wird, der durch eine Bohrung im Kühlkörper unmittelbar an die zu kühlende Fläche des Bausteins gebracht wird.

Die Abdichtung des Kühlkörpers zur Vakuumkammer erfolgt über einen elektrisch isolierenden Ring, der an seiner Ober- und Unterseite Nuten enthält, in denen Dichtungen eingefügt sind.

In weiterer Ausgestaltung der Erfindung kann der Kühlkörper in Höhe und Neigung zur Kontaktfläche mit dem Bauelement verstellbar sein.

Dabei ist es zweckmäßig, daß die Verstellbarkeit der Stirnfläche des Kühlkörpers über ein Kugelgelenk erfolgt. Die Verstellbarkeit der Höhe des Kühlkörpers wird durch federnde Verbindungen im Innern des Kühlkörpers sichergestellt.

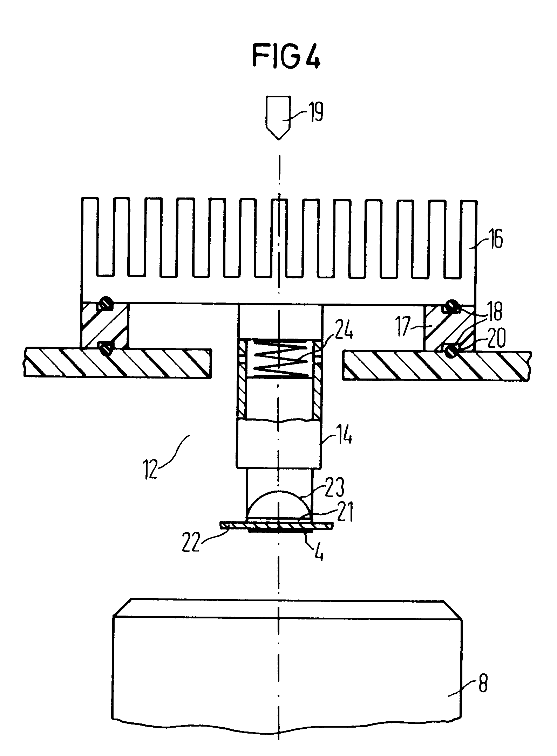

Anhand der Ausführungsbeispiele nach den FIG 3 und 4 wird die Erfindung näher erläutert.

Es zeigen
FIG 3 einen Ausschnitt aus einem Elektronenstrahlmeßgerät mit einem temperaturgeregelten Kühlkörper,
FIG 4 einen Ausschnitt aus einem Elektronenstrahlmeßgerät mit einem höhen- und neigungsverstellbaren Kühlkörper.

Die Abdeckhaube 2 des Elektronenstrahlmeßgerätes ist an seiner Oberseite mit einer Öffnung versehen, durch die der als Kühlstempel ausgebildete Kühlkörper 14 in das Innere der Vakuumkammer 12 hineinragt. Die Kühlrippen 16 des Kühlkörpers 14 befinden sich außerhalb der Vakuumkammer und sind mit dem Kühlkörper fest verbunden. Auf den Kühlrippen 16 wird temperaturgeregelte Kühlluft 19 geblasen. Der Istwert für die Temperaturregelung wird durch den Temperaturfühler 15 erzeugt, der durch eine Bohrung im Kühlkörper 14 bis auf weniger als 1mm an die Kühlfläche 22 des Bauelementes 4 herangebracht wird. Die Signalzuführungen erfolgen seitlich vom Kühlstempel versetzt.

Die Abdichtung zur Vakuumkammer 12 erfolgt über einen elektrisch isolierenden Ring 17 und über die entsprechend in den Nuten 20 des Ringes 17 eingelegten Dichtungen 18. Durch die Anordnung der Dichtungen wird erreicht, daß bei evakuierender Vakuumkammer 12 die Dichtringe 18 stärker angepreßt werden. Ein weiterer Vorteil dieser Lösung ist die geringe thermische Trägheit des Aufbaus, die schnelle Temperaturwechsel zur Detektion temperaturabhängiger Fehler ermöglicht.

Der Stempel kann dabei, wie in FIG 4 gezeigt, neigungs- und höhenabhängig verstellt werden. Diese Verstellung erfolgt durch ein Kugelgelenk 23, das an der Unterseite des Kühlkörpers 14 angebracht ist, wodurch die Stirnfläche 21 des Kühlkörpers 14 an die Lage der Kontaktfläche 22 des Bauteiles 4 angepaßt werden kann. Durch den Einsatz der federnden Verbindung 24 im Innern des Kühlkörpers 14 kann eine automatische Anpassung an unterschiedliche Höhen zwischen Kühlstempel und Bauelement 4 erreicht werden. Die Abdichtung zur Vakuumkammer 12 erfolgt wieder über den isolierenden Ring 17 und die Dichtungen 18, wobei durch die Höhe des isolierenden Ringes 17 bereits eine zusätzliche grobe Höhenjustage erfolgen kann. Die vorstehend beschriebene Kühlvorrichtung kann entsprechend angepaßt auch bei anderen Prüflingen, wie z.B. Leiterplatten, angewandt werden.

## Patentansprüche

1. Kühlvorrichtung für elektronische Bauelemente (4), die sich zum Zwecke der Funktionsprüfung mittels gebündelter Elektronen- oder Ionenstrahlen in einer Vakuumkammer befinden, **dadurch gekennzeichnet**, daß ein stempelartig ausgebildeter Kühlkörper (14) über eine an der Oberseite der Vakuumkammer (12) abgedichtete Öffnung in die Vakuumkammer eingesetzt und mit der Rückseite des Bauelementes (4) unmittelbar kontaktiert ist.

2. Kühlvorrichtung für Bauelemente nach Anspruch 1, **dadurch gekennzeichnet**, daß der Kühlkörper (14) außerhalb der Vakuumkammer (12) mit einer Kühlrippe (16) verbunden ist, die auf einer Abdeckhaube (2) der Vakuumkammer (12) befestigt sind.

3. Kühlvorrichtung für Bauelemente nach Anspruch 2, **dadurch gekennzeichnet**, daß die Abführung der Wärme an den Kühlrippen (16) durch auf sie aufgeblasene temperaturgeregelte Kühlluft (19) erfolgt.

4. Kühlvorrichtung für Bauelemente nach Anspruch 3, **dadurch gekennzeichnet**, daß der Istwert der Temperaturregelung durch einen Temperaturregler (15) erzeugt wird, der durch eine Bohrung im Kühlkörper (14) unmittelbar an die zu kühlende Fläche des Bauelementes (4) gebracht wird.

5. Kühlvorrichtung für Bauelemente nach einem der vorhergehenden Ansprüche, **dadurch gekennzeichnet**, daß die Abdichtung des Kühlkörpers (14) zur Vakuumkammer (12) über einen elektrisch isolierenden Ring (17) erfolgt, in dessen Ober- und Unterseite Dichtungen (18) in Nuten (20) eingelegt sind.

6. Kühlvorrichtung für Bauelemente nach einem der vorhergehenden Ansprüche, **dadurch gekennzeichnet**, daß der Kühlkörper in Höhe und Neigung zur Kontaktfläche mit dem Bauelement (4) verstellbar ist.

7. Kühlvorrichtung für Bauelemente nach Anspruch 6, **dadurch gekennzeichnet**, daß die Neigungsverstellbarkeit der Stirnfläche (21) des Kühlkörpers (14) über ein Kugelgelenk (23) erfolgt.

8. Kühlvorrichtung für Bauelemente nach einem der Ansprüche 6 oder 7, **dadurch gekennzeichnet**, daß die Höhenverstellbarkeit des Kühlkörpers (14) durch federnde Verbindungen (24) im Inneren des Kühlkörpers (14) erfolgt.

## Claims

1. Cooling device for electronic components (4) which are located in a vacuum chamber for the purpose of operational testing by means of focused electron beams or ion beams, characterized in that a heat sink (14) in the form of a plunger is inserted in the vacuum chamber via a sealed opening at the upper side of the vacuum chamber (12) and is in direct contact with the back side of the component (4).

2. Cooling device for components according to Claim 1, characterized in that the heat sink (14) is connected outside the vacuum chamber (12) to a cooling rib (16) which is mounted on a covering hood (2) of the vacuum chamber (12).

3. Cooling device for components according to Claim 2, characterized in that the heat is dissipated from the cooling ribs (16) by blowing temperature-regulated cooling air (19) onto them.

4. Cooling device for components according to Claim 3, characterized in that the actual value of the temperature regulation is generated by a temperature regulator (15) which is placed directly on the surface, to be cooled, of the component (4) through a hole in the heat sink (14).

5. Cooling device for components according to one of the preceding claims, characterized in that the sealing of the heat sink (14) with respect to the vacuum chamber (12) is made via an electrically insulating ring (17), into whose upper side and underside seals (18) are inserted in grooves (20).

6. Cooling device for components according to one of the preceding claims, characterized in that height and inclination of the heat sink with respect to the contact surface with the component (4) can be adjusted.

7. Cooling device for components according to Claim 6, characterized in that the inclination of the end surface (21) of the heat sink (14) is adjusted by means of a ball-and-socket joint (23).

8. Cooling device for components according to one of Claims 6 or 7, characterized in that the height of the heat sink (14) is adjusted by means of sprung connections (24) inside the heat sink (14).

## Revendications

1. Dispositif de refroidissement pour des composants électroniques (4) qui sont situés dans une chambre à vide en vue du contrôle de fonctionnement au moyen de faisceaux focalisés d'électrons ou d'ions, caractérisé par le fait qu'un corps de refroidissement (14), agencé sous la forme d'un poinçon, est inséré dans la chambre à vide par l'intermédiaire d'une ouverture fermée de façon étanche au niveau du côté supérieur de la chambre à vide (12) et est en contact direct avec la face arrière du composant (4).

2. Dispositif de refroidissement pour composants suivant la revendication 1, caractérisé par le fait que le corps de refroidissement (14) est relié, à l'extérieur de la chambre à vide (12), à une ailette de refroidissement (16), qui est fixée sur un capot de recouvrement (2) de la chambre à vide (12).

3. Dispositif de refroidissement pour composants suivant la revendication 2, caractérisé par le fait que l'évacuation de la chaleur est réalisée au niveau des ailettes de refroidissement (16), à l'aide d'un air de refroidissement (19) dont la température est réglée et qui est soufflé sur ces ailettes.

4. Dispositif de refroidissement pour composants suivant la revendication 3, caractérisé par le fait que la valeur réelle de la régulation de température est obtenue au moyen d'un régulateur de température (15), qui est amené, à travers un perçage ménagé dans le corps de refroidissement (14), directement contre la surface à refroidir du composant (4).

5. Dispositif de refroidissement pour composants suivant l'une des revendications précédentes, caractérisé par le fait que l'étanchéité du corps de refroidissement (14) par rapport à la chambre à vide (12) est obtenue au moyen d'une bague électriquement isolante (17), dans des gorges (20) des faces supérieure et inférieure de laquelle sont insérées des garnitures d'étanchéité (18).

6. Dispositif de refroidissement pour composants suivant l'une des revendications précédentes, caractérisé par le fait que la hauteur du corps de refroidissement et son inclinaison par rapport à la surface de contact avec le composant (4) sont réglables.

7. Dispositif de refroidissement pour composants suivant la revendication 6, caractérisé par le fait que la possibilité de réglage de l'inclinaison de la surface frontale (21) du corps dé refroidissement (14) est obtenue au moyen d'une articulation sphérique (23).

8. Dispositif de refroidissement pour composants suivant l'une des revendications 6 ou 7, caractérisé par le fait que la possibilité de réglage en hauteur du corps de refroidissement (14) est obtenue au moyen de liaisons élastiques (24) à l'intérieur du corps de refroidissement (14).
